# EUROPÄISCHE PATENTSCHRIFT

(11) **EP 3 012 856 B1**
(45) Veröffentlichungstag und Bekanntmachung des Hinweises auf die Patenterteilung: **04.12.2019**
(21) Anmeldenummer: 15190959.5
(22) Anmeldetag: 22.10.2015
(51) Int. Cl.: H01J 37/32, H05H 1/24

(54) **VERFAHREN UND VORRICHTUNG ZUR ERZEUGUNG EINER ELEKTRISCHEN ENTLADUNG**
METHOD AND DEVICE FOR GENERATING AN ELECTRICAL DISCHARGE
PROCEDE ET DISPOSITIF DE GENERATION DE DECHARGE ELECTRIQUE

(30) Priorität: 24.10.2014 DE 102014115492
(43) Veröffentlichungstag der Anmeldung: 27.04.2016
(73) Patentinhaber: CemeCon AG, 52146 Würselen (DE)
(72) Erfinder: MAY, Walter, 52078 Aachen (DE)
(74) Vertreter: Kalkoff & Partner

(56) Entgegenhaltungen:
- DE-A1- 10 060 002
- DE-B3-102011 056 555
- US-A- 4 475 063
- SHERMAN A: "BRIEF REPORT AND COMMENT", JOURNAL OF VACUUM SCIENCE AND TECHNOLOGY: PART B, AVS / AIP, MELVILLE, NEW YORK, NY, US, Bd. 8, Nr. 4, 1. Juli 1990 (1990-07-01), Seiten 656-657, XP000358583, ISSN: 1071-1023, DOI: 10.1116/1.584991

## Beschreibung

Die Erfindung betrifft eine Vorrichtung und ein Verfahren zur Erzeugung einer elektrischen Entladung. Insbesondere betrifft die Erfindung die Erzeugung einer elektrischen Ladung innerhalb einer Kammer, bspw. einer Vakuum-Kammer für Plasmabehandlung.

Es sind eine Vielzahl von Vorrichtungen und Verfahren bekannt, bei denen Werkstücke innerhalb einer Vakuum-Kammer mit einem elektrisch erzeugten Plasma behandelt werden, bspw. in Form von Plasma-Beschichtung oder Plasma-Ätzen.

Bspw. beschreibt die DE 10 2006 021994 A1 ein Beschichtungsverfahren und eine Vorrichtung zum Beschichten von Körpern mittels Magnetron Sputtern. In einer PVD-Magnetron Beschichtungskammer sind Magnetrons gegen eine gemeinsame Anode verschaltet. Auf einem Drehteller werden Substrate an den Magnetrons vorbeigeführt. Mittels zweier Leistungsversorgungen kann ein Magnetron gepulst oder mit konstanter Leistung betrieben werden. Unmittelbar vor der Beschichtung wird das Substrat einer Plasma-Ätzbehandlung unterzogen, indem das Substrat mit einem negativen Potenzial beaufschlagt und mit Argon-Ionen beschossen wird, um die Oberfläche zu reinigen und zu aktivieren.

Die DE 10 2004 015 231 A1 beschreibt ein Verfahren und eine Vorrichtung zur Behandlung von Substratoberflächen mittels Ladungsträgerbeschuss. Zum Zwecke der Oberflächenbehandlung wird zwischen einer Elektronenemissionseinrichtung und einer als Anode geschalteten Elektrode eine stromstarke Gasentladung ausgebildet. Nach dem Evakuieren einer Vakuum-Kammer wird eine in die Wandung der Kammer eingebaute Hohlkathode in Betrieb gesetzt mit einem geheizten Wolframröhrchen, einem gekühlten Gehäuse, einer Einlassvorrichtung für das Trägergas Argon und einer Hilfselektrode mit positiver Vorspannung, welche das Zünden und Stabilisieren einer Hohlkathodenbogenentladung unterstützt.

In der DE 10 2004 015 230 sind ein Verfahren und eine Vorrichtung zum Intensivieren einer gepulsten Magnetronentladung beschrieben. Eine Elektrode ist an einem Magnetron-Magnetfeld angeordnet und zeitweise gegenüber einer Gegenelektrode als Kathode geschaltet. In Zeitabschnitten, in denen die erste Elektrode nicht kathodisch betrieben wird, wird ein zusätzlicher Elektronenstrom aus einer zusätzlichen Elektronenquelle auf die erste Elektrode gelenkt. Als Elektronenquellen sind Hohlkathoden mit heißer Kathode sowie Draht- oder Bolzenkathoden aus Wolfram bzw. Lanthanhexaborid/Wolfram genannt. In einer Ausführungsform ist eine rohrförmige heiße Kathode von Argon-Gas durchströmt.

Die DE 100 60 002 A1 beschreibt eine Vorrichtung zur Oberflächenbehandlung mit einer Plasmaerzeugungskammer, die mit einer Plasmaerzeugungselektrode versehen ist, und eine Substratbehandlungskammer, die mit einem Substratträgertisch versehen ist. Eine Plasmadüse wird als Erzeugungsbereich für eine Hohlanodenentladung eingesetzt.

In dem Artikel von A. Sherman "In situ removal of native oxide from silicon wafers", J. Vac. Sci. Technol. B. 8, 1990, 4, 656, 657 wird für die CVD-Abscheidung auf Silizium in einem Reaktor eine wassergekühlte Hohlkathode aus Molybdän als Elektronenquelle für eine DC-Entladung verwendet.

Die US 4,475,063 A beschreibt eine Hohlkathoden-Vorrichtung, die besonders rasch und zuverlässig gestartet werden kann, wozu die Vorrichtung eine als Rohr gebildete Hohlkathode und eine Anode sowie eine entsprechende Leistungsversorgung aufweist. Im Betrieb wird das zu ionisierende Gas einer Vorkammer zugeführt, in der eine Zündvorrichtung angeordnet ist, die auf die Hohlkathode gerichtete Plasma-Stöße erzeugt, um die Hohlkathode bis zu einer Temperatur aufzuheizen, bei der diese Elektronen emittiert.

In der DE 10 2011 056 555 B3 wird eine Hohlkathode aus Molybdän mit einem Emissionsrohr aus Lanthanhexaborid beschrieben, wobei diese Keramik zu 0,5 bis 10% mit einem Element der 4. Periode der Gruppen 4 bis 11, vorzugsweise Eisen, Kobalt oder Nickel, dotiert ist, um ein Plasma mit einer besonders hohen Ionenstromdichte erzeugen zu können.

Es kann als Aufgabe der Erfindung angesehen werden, eine Vorrichtung und ein Verfahren vorzuschlagen, mit denen in einer Kammer auf einfache Weise eine elektrische Entladung erzeugt oder unterstützt werden kann.

Die Aufgabe wird gelöst durch eine Vorrichtung gemäß Anspruch 1 und ein Verfahren gemäß Anspruch 11. Abhängige Ansprüche beziehen sich auf vorteilhafte Ausführungsformen der Erfindung.

Erfindungsgemäß sind in einer Kammer, bevorzugt einer Vakuumkammer, mindestens eine erste und eine zweite Elektrode vorgesehen. Durch eine elektrische Leistungsversorgung kann mindestens zeitweise die erste Elektrode als Kathode und die zweite Elektrode als Anode geschaltet werden.

Durch die erste, als Kathode zu schaltende Elektrode wird ein Gas in die Kammer eingeleitet. Dabei erfolgt erfindungsgemäß zunächst eine Zuführung des Gases in eine abgeschlossene Vorkammer, die eine metallische Wandung aufweist. Aus der Vorkammer gelangt das Gas durch ein Rohr in die Kammer.

Erfindungsgemäß ist dabei das Rohr so an der Wandung der Vorkammer ausgerichtet, dass es mit seinem vorderen, in Richtung der Kammer ausgerichteten Bereich oder Abschnitt, durch den das Gas in die Kammer hineingeleitet wird, in der Wandung der Vorkammer eingebettet ist, während es mit seinem hinteren Bereich oder Abschnitt, in dem das Gas aus der Vorkammer in das Rohr gelangt, frei in die Vorkammer hineinragt. Weiterhin erfindungsgemäß ragt das Rohr mit mindestens der Hälfte seiner Länge frei in die Vorkammer hinein.

Bei einer solchermaßen gestalteten Elektrode befindet sich der vordere, in der Wandung eingebettete Bereich oder Abschnitt des Rohrs in guter thermischer Kopplung mit der Wandung der Vorkammer, so dass dort auftretende Wärme über die Wandung der Vorkammer, die bevorzugt aus einem gut wärmeleitenden Metall, wie bspw. Kupfer besteht, abgeleitet wird. Das hintere Ende des Rohrs ragt aber frei in die Vorkammer hinein, weist also deutlich schlechtere thermische Kopplung an die Wandung der Vorkammer auf. Somit kann sich das Material des Rohrs an dieser Stelle erwärmen.

Bei der Zuführung von Gas durch das Rohr in die Kammer können sich an dem Rohr eine Hohlkathodenentladung und insbesondere eine Hohlkathodenbogenentladung ausbilden. Es hat sich gezeigt, dass durch eine starke Erwärmung des in die Vorkammer hineinragenden freien Endes des Rohrs, in das das Gas aus der Vorkammer hineinströmt, dort durch Glühemission Elektronen aus dem Material des Rohrs austreten. Die Elektronen unterstützen die Ausbildung einer Hohlkathodenbogenentladung und gelangen zusammen mit dem Gasstrom durch das Rohr hindurch in die Kammer. Hierdurch ergibt sich eine für eine Plasma-Behandlung in der Kammer geeignete hohe Ionisation.

Erfindungsgemäß besteht das Rohr aus einem anderen Material als die Wandung der Vorkammer, in die es eingebettet ist. Hierdurch ist es möglich, dass das jeweilige Material für die Wandung und das Rohr unabhängig voneinander entsprechend der gewünschten Funktion geeignet gewählt werden kann. Das Rohr kann bspw. in einer im Material der Wandung der Vorkammer gebildeten Öffnung passend eingesetzt oder eingepresst sein, so dass eine gute Anlage zwischen der Wandung und dem Rohr erreicht wird.

Das Rohr sollte möglichst aus einem Material bestehen, das gegenüber den Temperaturen beständig ist, die sich bei den auftretenden elektrischen Entladungen ergeben. So kann übermäßiger Abbrand vermieden werden. Für das Material des Rohrs kommen verschiedene Werkstoffe in Frage, insbesondere Metalle und keramische Werkstoffe. Bevorzugt werden hoch temperaturfeste Materialien, d.h. solche, die einen besonders hohen Schmelzpunkt von über 1500°, bevorzugt von über 2.000° C aufweisen. In bevorzugten Ausführungen kann das Rohr bspw. aus Tantal, Wolfram oder Lanthanhexaborid (LaB₆) bestehen. Besonders bevorzugt ist dabei Tantal als Material. Ein aus diesen Materialien gebildetes Rohr erweist sich als beständig und weist trotz der bei den auftretenden Entladungen erreichten hohen Temperaturen kaum Abbrand auf.

Für das Material der Wandung der Vorkammer ist eine gute Verarbeitbarkeit und Formbarkeit zur Bildung der Wandung, insbesondere einer massiven Wandung, günstig. Bevorzugt wird ein Material der Wandung, das eine gute Wärmeleitfähigkeit aufweist, bspw. mehr als 100 W/(mK), bevorzugt mehr als 200 W/(mK), besonders bevorzugt von mehr als 300 W/(mK) um die bei der Entladung entstehende Wärme ableiten zu können. Beispielsweise kann Aluminium verwendet werden, bevorzugt ist allerdings Kupfer oder eine Legierung, die zumindest überwiegend, d.h. zu mehr als 50 at-% aus Kupfer besteht. Ein Material mit einem besonders hohen Schmelzpunkt wird hingegen für das Material der Vorkammer nicht benötigt, bspw. kann ein Metall mit einem Schmelzpunkt von weniger als 1200°C verwendet werden.

Das Rohr kann bevorzugt einen runden Querschnitt aufweisen. Weiter bevorzugt ist es von länglicher Form, d.h. seine axiale Länge ist länger als der äußere Durchmesser, bevorzugt mehr als doppelt so groß, weiter bevorzugt mehr als dreifach so groß wie der Durchmesser. Bspw. kann das Rohr eine Länge von 10 - 40 mm aufweisen, bevorzugt 20 - 30 mm. Als Außendurchmesser sind z. B. Abmessungen von 4 - 15 mm, bevorzugt 10 mm oder weniger denkbar. Der Innendurchmesser kann bspw. weniger als 10 mm betragen, bevorzugt 6 mm oder weniger.

Im vorderen Bereich oder Abschnitt ist bevorzugt, dass das Rohr mit der Wandung mindestens im Wesentlichen abschließt, d.h. nicht oder nur minimal aus der Wandung in die Kammer hineinragt.

Für die Zuführung von Gas in die Vorkammer kann ein Zuführrohr vorgesehen sein. Das Zuführrohr kann dabei zur Einleitung des Gases dienen, ohne selbst an der Entladung beteiligt zu sein. Das Zuführrohr kann mit einem vorderen, freien Ende in die Vorkammer hineinragen. Weiter kann das Zuführrohr gleiche oder ähnliche Eigenschaften aufweisen wie das Rohr zwischen Vorkammer und Kammer, d.h. als Material ist ein hoch temperaturfestes Material, bspw. Tantal, Wolfram oder Lanthanhexaborid bevorzugt, das Zuführrohr kann von rundem Querschnitt und länglicher Form sein und kann über mehr als die Hälfte seiner Länge frei in die Vorkammer hineinragen. Im hinteren Bereich oder Abschnitt ist das Zuführrohr bevorzugt in gut wärmeleitendes Material eingebettet.

Nachfolgend wird eine Ausführungsform der Erfindung anhand von Zeichnungen näher beschrieben. Darin zeigen:
- Fig. 1: in schematischer Darstellung eine Vakuumkammer mit Elektroden;
- Fig. 2: einen Querschnitt durch eine erste Elektrode der Kammer aus Fig. 1;
- Fig. 3: ein Diagramm des Spannungsverlaufs zwischen den Elektroden aus Fig. 1 über die Zeit.

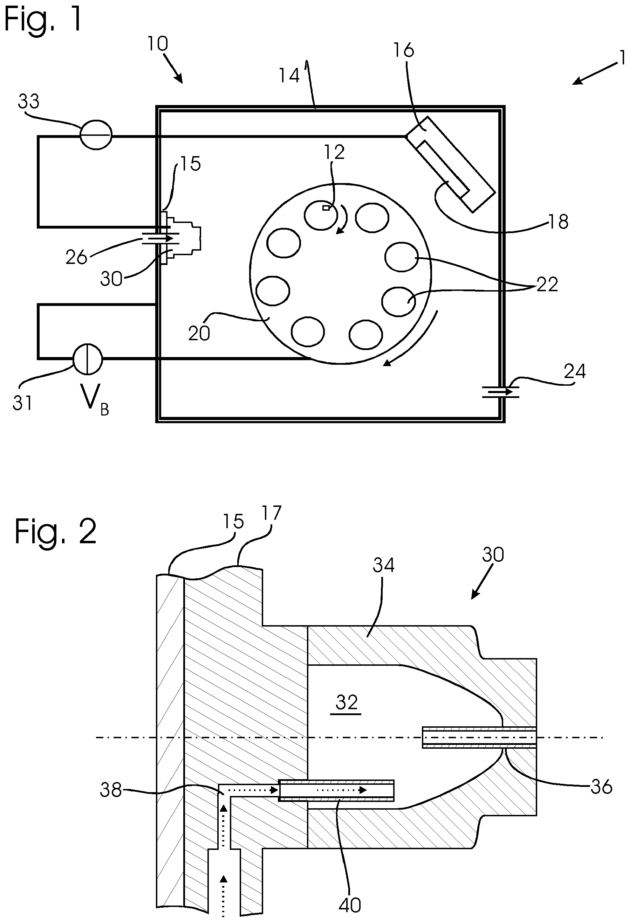

In Fig. 1 ist schematisch eine PVD-Sputteranlage 10 zum Beschichten von Substraten 12 dargestellt. In einer Vakuumkammer 14 ist eine Magnetron-Kathode 16 mit einem Sputtertarget 18 aus zu sputterndem Material angeordnet. In der Kammer 14 befindet sich ein drehbarer Substrattisch 20. Auf dem Substrattisch 20 drehen sich Substrathalter 22 mit daran angeordneten zu behandelnden Substraten 12, von denen in Fig. 1 nur ein einziges Substrat 12 symbolisch gezeigt ist.

Am Substrattisch 20 ist eine Bias-Leistungsversorgung 31 vorgesehen, mit der die Substrate 12 gegenüber der leitfähigen Wandung der Kammer 14 als Rezipienten auf einem negativen Potential gehalten werden.

Die Kammer 14 verfügt über einen Gasauslass 24, durch den über ein Pumpensystem (nicht dargestellt) ein Vakuum im Inneren der Kammer 14 erzeugt wird. Durch einen Gaseinlass 26 kann Arbeitsgas, bevorzugt Argon, sowie zusätzlich auch je nach gewünschter Behandlung Reaktivgas, bspw. Stickstoff, zugeführt werden.

Bei der in Fig. 1 dargestellten Beschichtungsanlage 10 ist der Gaseinlass 26 durch eine spezielle Elektrode 30 mit dem Inneren der Kammer 14 verbunden, so dass das Gas durch die Elektrode 30 in die Kammer strömt. Zwischen der Elektrode 30 und der Magnetron-Kathode 16 ist eine elektrische Leistungsversorgung 33 vorgesehen.

Die PVD-Beschichtungsanlage 10 ist hier lediglich schematisch mit einigen der darin enthaltenen Elemente dargestellt. PVD-Beschichtungsanlagen und insbesondere Anlagen zum Magnetron-Sputtern sind an sich bekannt. Die Beschichtung der Substrate 12 erfolgt durch Zünden eines Plasmas im Inneren der Kammer 14. Ionen des Plasmas zerstäuben das Target 18. Bestandteile des Plasmas lagern sich auf der Oberfläche der Substrate 12 ab. Während der Beschichtung kann die Elektrode 30 gegenüber der Magnetron-Kathode 16 als Anode geschaltet werden.

Sputter-Anlagen enthalten neben den in Fig. 1 dargestellten Elementen üblicherweise zusätzliche Elemente, bspw. weitere Sputter-Kathoden, insbesondere Magnetron-Kathoden vom unbalancierten Typ (UBM). Auf die detaillierte Darstellung und Erläuterung weiterer Elemente, die dem Fachmann ohnehin geläufig sind, soll an dieser Stelle verzichtet werden. Bspw. zeigt die WO 98/46807 A1 eine PVD-Beschichtungsanlage, zu der die elektrische Konfiguration mit Bias-Leistungsversorgung, separaten Leistungsversorgungen für mehrere Magnetron-Kathoden und eine zusätzliche Leistungsversorgung zwischen der metallischen Wandung der Kammer 14 und einer separaten Anode beschrieben ist. In der WO 2009/132822 sind eine PVD-Anlage und hiermit ausgeführte Beschichtungsverfahren beschrieben, bei denen mindestens einzelne der Sputter-Kathoden mit hochenergetischen Pulsen im HPPMS-Betrieb verwendet werden. Auf diese Druckschriften sowie die darin beschriebenen Anlagen und Verfahren wird hier im Hinblick auf mögliche Elemente einer Sputter-Anlage und deren elektrischer Verschaltung ausdrücklich Bezug genommen.

Für die Reinigung und Aktivierung der Oberfläche der Substrate 12 vor dem eigentlichen Beschichten im Sputter-Verfahren wird bevorzugt zunächst ein Ionen-Ätzen durchgeführt, bei dem geladene Teilchen auf die Oberfläche der Substrate 12 einwirken. Im gezeigten Beispiel von Fig. 1 erfolgt dieses Ätzen durch eine elektrische Entladung, die zwischen der Magnetron-Kathode 16 und der Elektrode 30 am Gaseinlass 26 gebildet wird. Dabei ist die Elektrode 30 als Kathode geschaltet, während die (wegen ihrer Verwendung als Kathode im späteren Beschichtungsverfahren durchgängig als "Magnetron-Kathode" bezeichnete) Elektrode 16 als Anode geschaltet ist.

Die Elektrode 30 ist im gezeigten Beispiel etwa mittig auf der Wandung der Kammer 14 aufgesetzt. Sie ist durch eine Isolierschicht 15 elektrisch gegenüber der elektrisch leitfähigen Kammerwandung 14 isoliert. Die Elektrode 30 und die als Gegenelektrode geschaltete Magnetron-Kathode 16 sind in der Kammer 14 einander gegenüberliegend so angeordnet, dass die Substrate sich im Bereich dazwischen befinden.

Fig. 2 zeigt in einem schematischen Querschnitt den Aufbau der Elektrode 30. Die Elektrode 30 umfasst eine Grundplatte 17 und einen darauf aufgesetzten Dom 34, die aus elektrisch leitfähigem Material gebildet sind. In einer bevorzugten Ausführung weist insbesondere der Dom 34 eine dicke Kupfer-Wandung, die eine Vorkammer 32 einschließt. Der Dom 34 ist direkt auf der Grundplatte 17 aufgesetzt, so dass diese elektrisch miteinander kontaktiert sind. Somit ist die Vorkammer rundum von einer Wandung aus durchgängig leitfähigem Material umgeben, so dass die Wandung im Betrieb stets auf einem einheitlichen elektrischen Potential ist. An der Grundplatte 17 kann bevorzugt eine Flüssigkeitskühlung für die Elektrode 30 vorgesehen sein.

Die Vorkammer 32 ist vom Inneren der Kammer 14 abgeschlossen und mit diesem nur durch ein Rohr bzw. Röhrchen 36 verbunden. Über einen Kanal 38 in der Wandung der Grundplatte 17 erfolgt die Zuführung von Gas, hier bevorzugt Argon als Arbeitsgas.

Das zugeführte Gas gelangt durch den Kanal 38 in der Grundplatte 17 sowie durch ein Zuführ-Röhrchen 40 in das Innere der Vorkammer 32. Aus der Vorkammer 32 gelangt das Gas dann durch das Röhrchen 36 in das Innere der Kammer 14.

Das Röhrchen 36 ist wie in Fig. 2 gezeigt ein von der Wandung der Vorkammer 32 separates Teil, von dem ein vorderer, zum Inneren der Kammer 14 weisender Abschnitt, der etwa einem Drittel der Gesamtlänge des Röhrchens 36 entspricht, in die Wandung 34 der Vorkammer 32 eingebettet ist.

Das Material des Röhrchens 36 unterscheidet sich von dem Material der Wandung der Vorkammer 32, insbesondere von dem Material des Doms 34. Der Dom 34 ist aus Kupfer als einem gut wärmeleitenden Material gebildet, das allerdings nicht hoch temperaturbeständig ist. Das Röhrchen hingegen besteht aus einem hoch temperaturfesten Material, bevorzugt Tantal.

Das Röhrchen 36 weist in der bevorzugten Ausführungsform eine Länge von 25 mm, einen Innendurchmesser von 4 mm und einen Außendurchmesser von 6 mm auf . Durch die Einbettung in die relativ dicke Kupfer-Wandung 34 ist das Tantal-Röhrchen 36 in seinem vorderen Abschnitt thermisch mit einem relativ großen Wärmereservoir gut gekoppelt, so dass Wärme von dort schnell abgeführt wird.

Mit seinem hinteren Ende ragt das Tantal-Röhrchen 36 allerdings frei in das Innere der Vorkammer 32 hinein. Der hintere, frei in die Vorkammer 32 hineinragende Abschnitt des Tantal-Röhrchens 36 entspricht dabei mehr als der Hälfte der Gesamtlänge des Röhrchens. Dadurch befindet sich das hintere Ende des Röhrchens 36 nicht in direkter thermischer Kopplung mit der Wandung 34 der Vorkammer 32, so dass dort auftretende Wärme nicht unmittelbar durch die Wandung 34 abgeführt wird.

Auch das Zuführ-Röhrchen 40 ragt im gezeigten Beispiel in die Vorkammer 32 hinein. Das Zuführ-Röhrchen 40 besteht ebenfalls aus Tantal und kann in etwa dieselben Abmessungen aufweisen wie das Röhrchen 36. Das Zuführ-Röhrchen 40 ragt mit seinem vorderen Abschnitt frei in das Innere der Vorkammer 32. Es dient zur Einleitung des Arbeitsgases in die Vorkammer 32 und hat somit die Funktion einer Düse, ist aber nicht an der Entladung beteiligt.

Im Ätzbetrieb der Anlage 10 gem. der Skizze aus Fig. 1, wird die Leistungsversorgung 32 als Stromquelle mit einem festen vorgegebenen Strom betrieben. Dies führt zunächst zum Anlegen einer Spannung von bspw. 400 - 900V. Bei gleichzeitiger Zuführung von Argon als Arbeitsgas durch den Kanal 38 und das Zuführ-Röhrchen 40 bildet sich zunächst eine Hohlkathoden-Entladung; so dass sich eine Erwärmung des Röhrchens 36 ergibt. Dabei bildet sich über die Länge des Röhrchens 36 eine Temperaturverteilung aus, bei der das hintere Ende des Röhrchens 36 eine erheblich höhere Temperatur aufweist als dessen vorderes Ende, weil die Wärme am vorderen Ende durch die Wandung 34 abgeleitet wird.

Gerät das Material des Röhrchens 36 durch die Erwärmung in einen Temperaturbereich, in dem eine nennenswerte Emission von Elektronen aus dem Material durch den glühelektrischen Effekt erfolgt, so treten diese Elektronen hauptsächlich im Bereich des hinteren Endes des Röhrchens 36 aus und führen zur Ausbildung einer Hohlkathodenbogenentladung. Die Elektronen gelangen mit dem Gasstrom durch das Röhrchen 36 in das Innere der Kammer 14. Im Inneren der Kammer 14 werden die Elektronen von der als Anode geschalteten Magnetron-Kathode 16 angezogen und in deren Richtung beschleunigt. Durch die beschleunigten Elektronen kommt es dabei auch zu weiterer Ionisation von Bestandteilen im Inneren der Kammer 14, insbesondere zur Bildung von Argon-Ionen, mit denen die Oberfläche des Substrats 12 behandelt werden kann.

Dabei erweist sich, dass das Röhrchen 36 nur einen relativ geringen Verschleiß bzw. Abbrand erfährt. Die dort gezündete Entladung ist insbesondere ab dem Erreichen einer Glühtemperatur von ca. 2.500°C sehr stabil und bildet sich gut reproduzierbar aus.

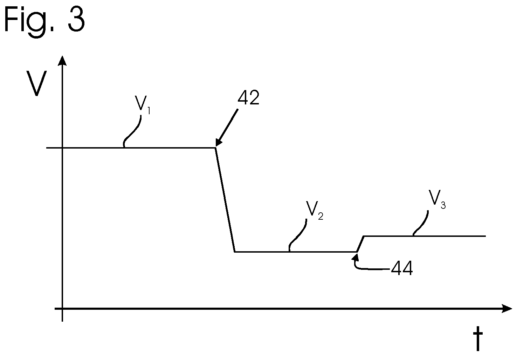

Fig. 3 zeigt beispielhaft einen Verlauf der zwischen den Elektroden 30, 16 anliegenden Spannung V über die Zeit t. Dort stellt sich zunächst durch die Leistungsversorgung 33 eine Zündspannung V₁ von bspw. ca. 700V ein. Nach einiger Zeit zündet im Punkt 42 die Hohlkathoden-Entladung, so dass die Spannung auf einen deutlich geringeren Wert von bspw. 50V absinkt.

Das Röhrchen 36 erwärmt sich dann insbesondere an seinem hinteren Ende, bis nach einem Zeitintervall zum Zeitpunkt 44 der Effekt der Glühemission aus dem Tantal-Material des Röhrchens 36 an dessen hinteren Ende deutlich merkbar wird, wodurch sich die Entladung in eine Hohlkathodenbogenentladung verändert und ein geringfügiger Anstieg auf eine dritte Spannung V₃ erfolgt. Die dritte Spannung V₃ kann bspw. 65V betragen, liegt also lediglich geringfügig oberhalb der zweiten Spannung V₂.

Die weitere Entladung auf dem Spannungsniveau V₃ erweist sich dann als außerordentlich stabil.

Zu den gezeigten Ausführungen sind eine Anzahl von Änderungen bzw. Alternativen möglich. So können insbesondere in der Anlage gemäß Fig. 1 neben der Elektrode 30 noch eine oder mehrere weiterer solcher Elektroden vorgesehen sein. Bevorzugt kann zu jeder der Elektroden eine separate zusätzliche Leistungsversorgung vorgesehen sein, weiter bevorzugt angeschlossen an jeweils eine separate Gegenelektrode. Weiter ist bevorzugt, dass wie schon bei der Anordnung der in Fig. 1 gezeigten Elektroden 16, 30 die Halterung für die Substrate 12 zwischen den Elektroden angeordnet ist, um so eine Einwirkung des entstehenden Plasmas auf die Substrate 12 zu erhalten.

Während im vorstehenden Beispiel die gezeigte Anlage 1 eine Sputter-Anlage ist, kann eine Behandlung durch die Entladung zwischen den Elektroden 16 und 30 auch unabhängig hiervon in jeder anderen Kammer bzw. jedem anderen Typ von Plasma-Behandlungsanlage verwendet werden.

## Patentansprüche

1. Vorrichtung zur Erzeugung einer elektrischen Entladung mit
- mindestens einer ersten und einer zweiten Elektrode (30, 16) in einer Kammer (14), wobei eine elektrische Leistungsversorgung (33) vorgesehen ist, um die erste Elektrode (30) als Kathode und die zweite Elektrode (16) als Anode zu schalten,
- wobei die erste Elektrode (30) eine abgeschlossene Vorkammer (32) mit einer metallischen Wandung (34) und eine Gaszuführung (38, 40) in die Vorkammer (32) aufweist,
- und wobei ein Rohr (36) vorgesehen ist, um Gas aus der Vorkammer (32) in die Kammer (14) zu leiten, wobei das Rohr (36) in einem vorderen, in Richtung der Kammer (14) ausgerichteten Bereich in der Wandung (34) der Vorkammer (32) eingebettet ist,
- und wobei das Rohr (36) in einem hinteren Bereich, in den Gas aus der Vorkammer (32) eintreten kann, ein frei in die Vorkammer hineinragendes Ende aufweist,
**dadurch gekennzeichnet, dass**
- das Rohr (36) aus einem anderen Material als die Wandung der Vorkammer (32) gebildet ist
- und mehr als die Hälfte der Länge des Rohrs (36) frei in die Vorkammer (32) ragt.

2. Vorrichtung nach Anspruch 1, bei der
- das Rohr (36) aus einem Material besteht, das einen Schmelzpunkt von über 1500°C aufweist.

3. Vorrichtung nach einem der vorangehenden Ansprüche, bei der
- das Rohr (36) aus Tantal, Wolfram oder Lanthanhexaborid besteht.

4. Vorrichtung nach einem der vorangehenden Ansprüche, bei der
- die Wandung (34) der Vorkammer (32) aus einem Metall einer Wärmeleitfähigkeit von mehr als 100 W/(mK) besteht.

5. Vorrichtung nach einem der vorangehenden Ansprüche, bei der
- die Wandung (34) der Vorkammer (32) aus einem Metall mit einem Schmelzpunkt von weniger als 1200°C besteht.

6. Vorrichtung nach einem der vorangehenden Ansprüche, bei der
- die Wandung (34) der Vorkammer (32) aus Kupfer oder einer zu mehr als 50 at-% aus Kupfer bestehenden Legierung gebildet ist.

7. Vorrichtung nach einem der vorangehenden Ansprüche, bei der
- das Rohr (36) aus einem Material mit einem Schmelzpunkt von über 2.000°C besteht.

8. Vorrichtung nach einem der vorangehenden Ansprüche, bei der
- die Länge des Rohrs (36) mehr als doppelt so groß wie sein äußerer Durchmesser ist.

9. Vorrichtung nach einem der vorangehenden Ansprüche, bei der
- das Rohr (36) im vorderen Bereich mit der Wandung (34) abschließt.

10. Vorrichtung nach einem der vorangehenden Ansprüche, bei der
- die Elektrode (30) eine Grundplatte (17) und einen darauf aufgesetzten Dom umfasst und an der Grundplatte (17) eine Flüssigkeitskühlung für die Elektrode (30) vorgesehen ist.

11. Vorrichtung nach einem der vorangehenden Ansprüche, bei der
- ein Zuführ-Rohr (40) vorgesehen ist, um Gas hierdurch in die Vorkammer (32) einzuleiten.

12. Vorrichtung nach Anspruch 11, bei der
- das Zuführ-Rohr (40) mit einem vorderen Ende, aus dem Gas in die Vorkammer (32) strömen kann, in die Vorkammer (32) hineinragt.

13. Verfahren zur Erzeugung einer elektrischen Entladung, bei dem
- in einer Kammer (14) eine erste Elektrode (30) gegenüber einer zweiten Elektrode (16) als Kathode geschaltet wird,
- und durch die erste Elektrode (30) ein Gas in die Kammer (14) eingeleitet wird, wobei das Gas durch eine abgeschlossene Vorkammer (32) der ersten Elektrode (30) mit einer metallischen Wandung (34) geleitet wird,
- und wobei Gas aus der Vorkammer (32) durch ein Rohr (36) aus einem anderen Material als die Wandung (34) der Kammer (14) in die Kammer (14) geleitet wird, wobei das Rohr (36) in einem vorderen Bereich, aus dem das Gas austritt, in der Wandung (34) der Vorkammer (32) eingebettet ist, und wobei das Rohr (36) in einem hinteren Bereich, in den das Gas aus der Vorkammer (32) eintritt, ein frei in die Vorkammer (32) hineinragendes Ende aufweist, wobei mehr als die Hälfte der Länge des Rohrs (36) frei in die Vorkammer (32) ragt.

## Claims

1. A device for generating an electrical discharge, comprising:
- at least a first and a second electrode (30, 16) in a chamber (14), wherein an electrical power supply (33) is provided in order to operate the first electrode (30) as a cathode and the second electrode (16) as an anode,
- wherein the first electrode (30) has a closed antechamber (32) having a metal wall (34) and a gas supply (38, 40) into the antechamber (32),
- and wherein a tube (36) is provided in order to conduct gas from the antechamber (32) into the chamber (14), wherein a front portion of the tube (36) facing the chamber (14) is embedded in the wall (34) of the antechamber (32),
- and wherein a rear portion of the tube (36), into which gas from the antechamber (32) can enter, has an end freely projecting into the antechamber,
**characterized in that**
- the tube (36) is formed from a material different from the material of the wall of the antechamber (32),
- and more than half of the length of the tube (36) projects freely into the antechamber (32).

2. The device according to claim 1, in which
- the tube (36) consists of a material which has a melting point above 1500°C.

3. The device according to one of the preceding claims, in which
- the tube (36) consists of tantalum, tungsten or lanthanum hexaboride.

4. The device according to one of the preceding claims, in which
- the wall (34) of the antechamber (32) consists of a metal with a thermal conductivity greater than 100 W/(mK).

5. The device according to one of the preceding claims, in which
- the wall (34) of the antechamber (32) consists of a metal with a melting point of less than 1200° C.

6. The device according to one of the preceding claims, in which
- the wall (34) of the antechamber (32) is formed from copper or an alloy that consists of more than 50 atomic percent of copper.

7. The device according to one of the preceding claims, in which
- the tube (36) consists of a material with a melting point above 2000°C.

8. The device according to one of the preceding claims, in which
- the length of the tube (36) is more than twice as large as its outer diameter.

9. The device according to one of the preceding claims, in which
- the front portion of the tube (36) terminates at the wall (34).

10. The device according to one of the preceding claims, in which
- the electrode (30) comprises a base plate (17) and a dome located thereon, and a liquid cooler for the electrode (30) is provided on the base plate (17).

11. The device according to one of the preceding claims, in which
- a feed tube (40) is provided in order to introduce gas through it into the antechamber (32).

12. The device according to claim 11, in which
- a front end of the feed tube (40), out of which gas can flow into the antechamber (32), projects into the antechamber (32).

13. A method for generating an electrical discharge, in which
- in a chamber (14), a first electrode (30) is operated as a cathode relative to a second electrode (16),
- and a gas is introduced into the chamber (14) through the first electrode (30), wherein the gas is conducted through a closed antechamber (32) of the first electrode (30) having a metal wall,
- and wherein gas is conducted from the antechamber (32) into the chamber (14) through a tube (36) consisting of a material different from the material of the wall (34) of the chamber (14), wherein a front portion of the tube (36), out of which the gas exits, is embedded in the wall (34) of the antechamber (32), and wherein a rear portion of the tube (36), into which the gas from the antechamber (32) enters, has an end freely projecting into the antechamber (32), wherein more than half of the length of the tube (36) projects freely into the antechamber (32).

## Revendications

1. Dispositif de génération de décharge électrique comprenant
- au moins une première et une seconde électrode (30, 16) dans une chambre (14), une alimentation électrique (33) étant prévue pour commuter la première électrode (30) en cathode et la seconde électrode (16) en anode,
- la première électrode (30) présentant une préchambre (32) fermée dotée d'une paroi métallique (34) et une alimentation en gaz (38, 40) dans la préchambre (32),
- et un tube (36) étant prévu pour faire passer du gaz de la préchambre (32) à la chambre (14), le tube (36) étant incorporé dans la paroi (34) de la préchambre (32) dans une zone avant, orientée en direction de la chambre (14),
- et le tube (36) présentant une extrémité dépassant librement dans la préchambre dans une zone arrière, dans laquelle du gaz provenant de la préchambre (32) peut pénétrer,
**caractérisé en ce que**
- le tube (36) est formé en un matériau différent de la paroi de la préchambre (32)
- et plus de la moitié de la longueur du tube (36) dépasse librement dans la préchambre (32).

2. Dispositif selon la revendication 1, dans lequel
- le tube (36) est constitué d'un matériau qui présente un point de fusion supérieur à 1500 °C.

3. Dispositif selon l'une des revendications précédentes, dans lequel
- le tube (36) est constitué de tantale, de tungstène ou d'hexaborure de lanthane.

4. Dispositif selon l'une des revendications précédentes, dans lequel
- la paroi (34) de la préchambre (32) est constituée d'un métal ayant une conductivité thermique supérieure à 100 W/(mK).

5. Dispositif selon l'une des revendications précédentes, dans lequel
- la paroi (34) de la préchambre (32) est constituée d'un métal ayant un point de fusion inférieur à 1200 °C.

6. Dispositif selon l'une des revendications précédentes, dans lequel
- la paroi (34) de la préchambre (32) est formé en cuivre ou en un alliage constitué à plus de 50 % at de cuivre.

7. Dispositif selon l'une des revendications précédentes, dans lequel
- le tube (36) est constitué d'un matériau ayant un point de fusion supérieur à 2 000 °C.

8. Dispositif selon l'une des revendications précédentes, dans lequel
- la longueur du tube (36) correspond à plus que deux fois son diamètre extérieur.

9. Dispositif selon l'une des revendications précédentes, dans lequel
- dans la zone avant, le tube (36) se termine avec la paroi (34).

10. Dispositif selon l'une des revendications précédentes, dans lequel
- l'électrode (30) comprend une plaque de base (17) et un dôme posé sur celle-ci et un refroidissement par liquide pour l'électrode (30) est prévu sur la plaque de base (17).

11. Dispositif selon l'une des revendications précédentes, dans lequel
- un tube d'alimentation (40) est prévu pour introduire du gaz par celui-ci dans la préchambre (32).

12. Dispositif selon la revendication 11, dans lequel
- le tube d'alimentation (40) dépasse dans la préchambre (32) avec une extrémité avant, de laquelle du gaz peut s'écouler dans la préchambre (32).

13. Procédé de génération de décharge électrique, dans lequel
- dans une chambre (14), une première électrode (30) est commutée en cathode par rapport à une seconde électrode (16),
- et un gaz est introduit dans la chambre (14) par la première électrode (30), le gaz étant guidé à travers une préchambre (32) fermée de la première électrode (30) dotée d'une paroi (34) métallique,
- et du gaz provenant de la préchambre (32) étant guidé dans la chambre (14) par un tube (36) en un matériau différent de la paroi (34) de la chambre (14), le tube (36) étant incorporé dans la paroi (34) de la préchambre (32) dans une zone avant, de laquelle le gaz sort, et le tube (36) présentant une extrémité dépassant librement dans la préchambre (32) dans une zone arrière, dans laquelle le gaz provenant de la préchambre (32) pénètre, plus de la moitié de la longueur du tube (36) dépassant librement dans la préchambre (32).
